(19) **Europäisches Patentamt**
**European Patent Office**
**Office européen des brevets**

(11) **EP 4 579 759 A1**

(12) **EUROPEAN PATENT APPLICATION**
published in accordance with Art. 153(4) EPC

(43) Date of publication:
02.07.2025  Bulletin 2025/27

(51) International Patent Classification (IPC):
*H01L 29/78* *(2006.01)*

(21) Application number: 23856932.1

(22) Date of filing: 07.06.2023

(52) Cooperative Patent Classification (CPC):
H10D 62/393; H10D 30/0297; H10D 30/60;
H10D 30/668; H10D 62/107; H10D 62/157;
H10D 62/8325; H10D 64/513; H10D 64/516

(86) International application number:
PCT/JP2023/021200

(87) International publication number:
WO 2024/042814 (29.02.2024 Gazette 2024/09)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 26.08.2022  JP 2022135237

(71) Applicant: **DENSO CORPORATION**
**Kariya-shi, Aichi  448-8661 (JP)**

(72) Inventor: **TAKAYA, Hidefumi**
**Kariya-shi, Aichi 448-8661 (JP)**

(74) Representative: **Kuhnen & Wacker**
**Patent- und Rechtsanwaltsbüro PartG mbB**
**Prinz-Ludwig-Straße 40A**
**85354 Freising (DE)**

(54)  **FIELD EFFECT TRANSISTOR**

(57)     Dielectric breakdown of a gate insulating film is suppressed when a current spreading n-layer is provided. A field effect transistor includes: a semiconductor substrate having a trench on an upper surface; a gate insulating film; and a gate electrode. The semiconductor substrate has a p-type body layer and a lower n-layer disposed below the body layer. The lower n-layer has: a current spreading n-layer in contact with the body layer from a lower side; and a low-concentration n-layer in contact with the current spreading n-layer from a lower side and having a lower n-type impurity concentration than the current spreading n-layer. An inner surface of the trench has a side surface having a radius of curvature of 0.7 $\mu$m or more, and a bottom connection surface connecting the side surface to a lower end of the trench and formed by a concave curved surface having a radius of curvature of less than 0.7 $\mu$m. A portion of the current spreading n-layer having the peak value is in contact with the gate insulating film on the side surface.

FIG. 2

EP 4 579 759 A1

**Description**

TECHNICAL FIELD

CROSS REFERENCE TO RELATED APPLICATIONS

This application relates to Japanese Patent Application No. 2022-135237 filed on August 26, 2022, and claims the benefit of priority from this Japanese Patent Application. The entire disclosures of all of this Japanese Patent Application are incorporated herein by reference in its entirety.

The present disclosure relates to a field effect transistor.

A field effect transistor disclosed in JP 2008-235546 A has a trench-type gate electrode. The field effect transistor has, in the area in contact with the gate insulating film, an n-type source layer, a p-type body layer, and a lower n-layer disposed below the body layer. When a predetermined potential is applied to the gate electrode, a channel is formed in the body layer, and the source layer and the lower n-layer are connected by the channel. This turns on the field effect transistor.

SUMMARY OF INVENTION

A current spreading n-layer having a high concentration of n-type impurities may be provided in the lower n-layer at an area adjacent to the body layer. With this configuration, electrons that have flowed from the channel into the lower n-layer diffuse laterally within the current spreading n-layer. Therefore, current is more likely to diffuse and flow in the region of the lower n-layer below the current spreading n-layer (so-called drift layer), and the on-resistance of the field effect transistor is reduced. However, when a current spreading n-layer is provided, a high electric field is likely to be generated in the gate insulating film in an area adjacent to the current spreading n-layer. This specification proposes a technique for suppressing dielectric breakdown of a gate insulating film when a current spreading n-layer is provided.

A field effect transistor disclosed in this specification includes: a semiconductor substrate having a trench on its upper surface; a gate insulating film covering an inner surface of the trench; and a gate electrode disposed within the trench and insulated from the semiconductor substrate by the gate insulating film. The semiconductor substrate has: an n-type source layer in contact with the gate insulating film; a p-type body layer in contact with the gate insulating film below the source layer; and a lower n-layer disposed below the body layer. The lower n-layer has: a current spreading n-layer in contact with the body layer from a lower side; and a low-concentration n-layer in contact with the current spreading n-layer from a lower side and having a lower n-type impurity concentration than the current spreading n-layer. The n-type impurity concentration is distributed so as to have a peak value in the current spreading n-layer in the depth direction of the semiconductor substrate. The inner surface of the trench has a side surface having a radius of curvature of 0.7 $\mu$m or more, and a bottom connection surface connecting the side surface to a lower end of the trench and formed by a concave curved surface having a radius of curvature of less than 0.7 $\mu$m. A portion of the current spreading n-layer having the peak value is in contact with the gate insulating film on the side surface.

A high electric field is likely to be applied to the gate insulating film in the area covering the bottom connection surface. Therefore, if a high concentration n-layer is in contact with the gate insulating film in the area covering the bottom connection surface, an excessively high electric field is likely to be applied to the gate insulating film in that area, making the gate insulating film prone to dielectric breakdown. In contrast, in the field effect transistor disclosed in this specification, the portion of the current spreading n-layer having the peak value is in contact with the gate insulating film on the side surface of the trench. The side surface of the trench is formed by a relatively flat surface having a radius of curvature of 0.7 $\mu$m or more. Therefore, even if the portion of the current spreading n-layer having the peak value on the side surface of the trench contacts the gate insulating film, it is possible to restrict the electric field applied to the gate insulating film from becoming excessively high. Therefore, in this field effect transistor, the gate insulating film is less susceptible to dielectric breakdown.

BRIEF DESCRIPTION OF DRAWINGS

FIG. 1 is a perspective and cross-sectional view of a MOSFET according to a first embodiment.
FIG. 2 is an enlarged cross-sectional view of an upper portion of the MOSFET according to the first embodiment.
FIG. 3 is an enlarged cross-sectional view of an upper portion of a MOSFET according to a second embodiment.
FIG. 4 is an enlarged cross-sectional view of an upper portion of a MOSFET according to a third embodiment.
FIG. 5 is an enlarged cross-sectional view of an upper portion of a MOSFET according to a fourth embodiment.
FIG. 6 is an enlarged cross-sectional view of an upper portion of a MOSFET according to a fifth embodiment.

DETAILED DESCRIPTION

In the above-described field effect transistor, the current spreading n-layer may not be in contact with the gate insulating film at the bottom connection surface.

According to this configuration, the dielectric breakdown of the gate insulating film can be more effectively suppressed.

The above-described field effect transistor may further include a bottom p-layer in contact with the gate insulating film at the lower end of the trench.

According to this configuration, the electric field applied to the gate insulating film around the lower end of the trench can be suppressed.

In the above-described field effect transistor, the bottom p-layer may be in contact with the current spreading n-layer in a range in contact with the gate insulating film. The current spreading n-layer between the body layer and the bottom p-layer may have a thickness of 0.1 $\mu$m or greater.

According to this configuration, the body layer and the bottom p-layer can be reliably separated by the current spreading n-layer.

First Embodiment

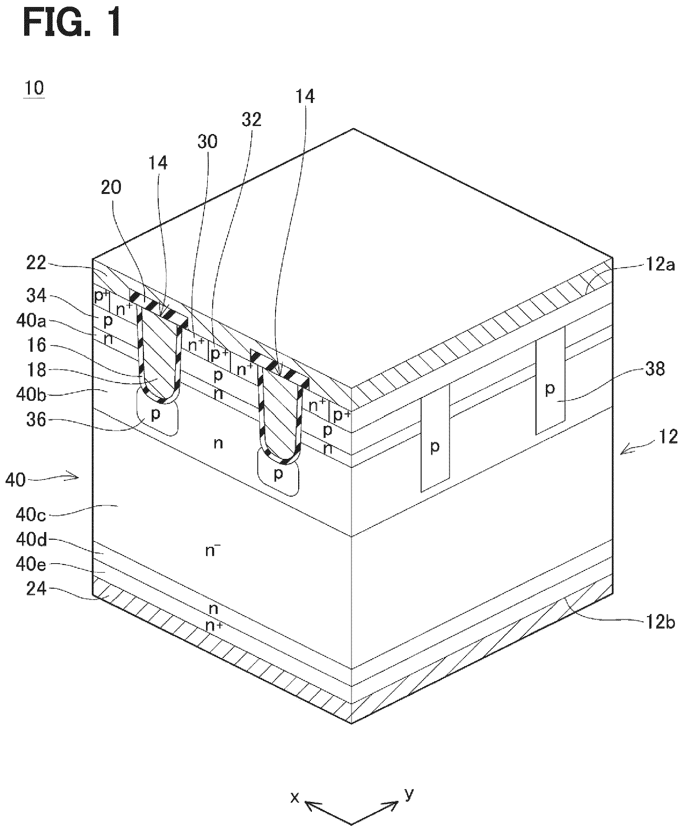

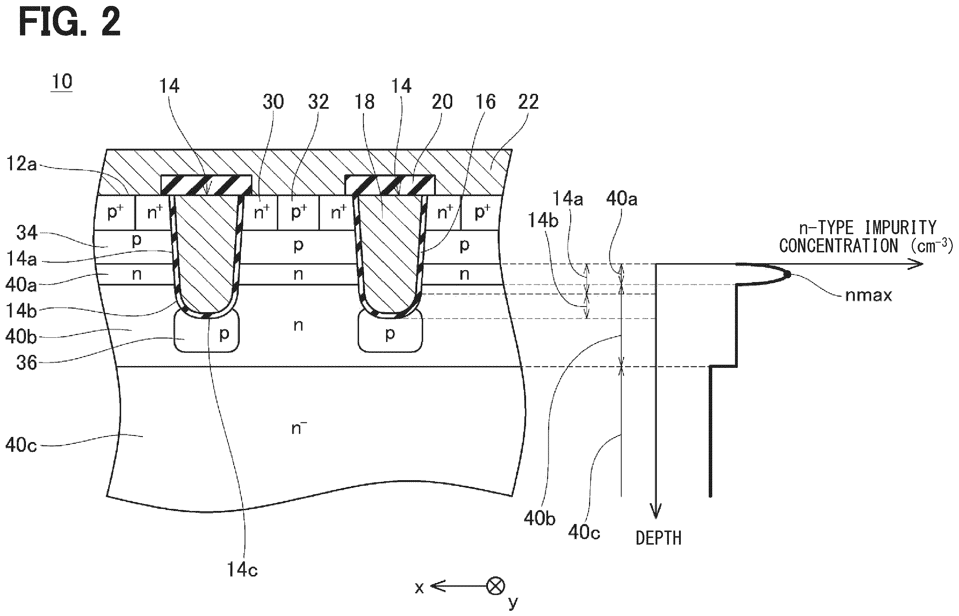

A metal-oxide-semiconductor field effect transistor (MOSFET) 10 shown in FIGS. 1 and 2 has a semiconductor substrate 12, in which an x direction is parallel to the upper surface 12a of the semiconductor substrate 12, and a y direction is parallel to the upper surface 12a and perpendicular to the x direction. The semiconductor substrate 12 is made of SiC. Alternatively, the semiconductor substrate 12 may be made of another semiconductor such as Si and GaN. Trenches 14 are provided in the upper surface 12a of the semiconductor substrate 12. Each of the trenches 14 extends in the y direction on the upper surface 12a. The trenches 14 are spaced apart from each other in the x-direction. An inner surface of each of the trenches 14 is covered with a gate insulating film 16. A gate electrode 18 is disposed in each of the trenches 14. The gate electrode 18 is insulated from the semiconductor substrate 12 by the gate insulating film 16. An upper surface of the gate electrode 18 is covered with an interlayer insulating film 20. A source electrode 22 is disposed on the upper portion of the semiconductor substrate 12. The source electrode 22 covers the upper surface 12a of the semiconductor substrate 12 and the interlayer insulating film 20. The source electrode 22 is insulated from the gate electrodes 18 by the interlayer insulating film 20. The lower surface 12b of the semiconductor substrate 12 is covered with a drain electrode 24.

As shown in FIG. 2, the trench 14 has a side surface 14a, a bottom connection surface 14b, and a bottom surface 14c. The side surface 14a is a flat surface (more specifically, a surface having a radius of curvature of 0.7 $\mu$m or more in the cross-section) that extends in the depth direction (i.e., thickness direction) of the semiconductor substrate 12. The bottom surface 14c extends approximately parallel to the upper surface 12a of the semiconductor substrate 12 and constitutes the lower end of the trench 14. The bottom connection surface 14b is a concave curved surface that connects the lower end of the side surface 14a and the bottom surface 14c. In the cross section, the radius of curvature of the bottom connection surface 14b is less than 0.7 $\mu$m.

The semiconductor substrate 12 includes a source layer 30, a body contact layer 32, a body layer 34, a bottom p-layer 36, a connection p-layer 38, and a lower n-layer 40.

The source layer 30 is an n-type layer, and is in contact with the gate insulating film 16 at the upper end of the side surface 14a of the trench 14. The source layers 30 is in ohmic contact with the source electrode 22.

The body contact layer 32 is a p-type layer, and is in ohmic contact with the source electrode 22 at a position adjacent to the source layer 30.

The body layer 34 is a p-type layer having a lower p-type impurity concentration than the body contact layer 32. The body layer 34 contacts the source layer 30 and the body contact layer 32 from the lower side. The body layer 34 is in contact with the gate insulating films 16 at position below the source layers 30. The body layer 34 is in contact with the gate insulating film 16 at the side surface 14a of the trench 14.

The bottom p-layer 36 is a p-type layer, and is in contact with the gate insulating film 16 at the bottom surface 14c of the trench 14. The bottom p-layer 36 extends in the y direction along the bottom surface 14c of the trench 14.

The connection p-layer 38 is a p-type layer, and protrudes downward from the body layer 34. The connection p-layer 38 extends linearly along the x direction when the semiconductor substrate 12 is viewed from the upper side. The connection p-layer 38 extends in the depth direction to the depth of the bottom p-layer 36. The connection p-layer 38 connects the body layer 34 and the bottom p-layer 36.

The lower n-layer 40 is disposed below the body layer 34. The lower n-layer 40 is separated from the source layer 30 by the body layer 34. The lower n-layer 40 is distributed from the position of the lower end of the body layer 34 to the lower surface 12b of the semiconductor substrate 12. The lower n-layer 40 includes a current spreading n-layer 40a, an electric field relaxation n-layer 40b, a drift layer 40c, a buffer layer 40d, and a drain layer 40e.

The current spreading n-layer 40a is an n-type layer having a relatively high concentration of n-type impurities. The current spreading n-layer 40a contacts the body layer 34 from the lower side. The current spreading n-layer 40a is in contact with the gate insulating film 16 below the body layer 34.

The electric field relaxation n-layer 40b is an n-type layer having a lower n-type impurity concentration than the current spreading n-layer 40a. The electric field relaxation n-layer 40b contacts the current spreading n-layer 40a from the lower side. The electric field relaxation n-layer 40b is distributed from the lower end of the current spreading n-layer 40a to a position below the bottom p-layer 36. The electric field relaxation n-layer 40b contacts the gate insulating film 16 below the current spreading n-layer 40a. The electric field relaxation n-layer 40b is in contact with the side surface and the bottom surface of the bottom p-layer 36.

The drift layer 40c is an n-type layer having a lower n-type impurity concentration than the electric field relaxation n-layer 40b. The drift layer 40c is in contact with the electric field relaxation n-layer 40b from the lower side.

The buffer layer 40d is an n-type layer having a higher n-type impurity concentration than the drift layer 40c. The buffer layer 40d contacts the drift layer 40c from the lower side.

The drain layer 40e is an n-type layer having a higher n-type impurity concentration than the buffer layer 40d. The drain layer 40e is in contact with the buffer layer 40d from the lower side. The drain layer 40e is in ohmic contact with the drain electrode 24.

As shown in FIG. 2, in the current spreading n-layer 40a, the n-type impurity concentration is distributed in the depth direction of the semiconductor substrate 12 in a normal distribution pattern. In the current spreading n-layer 40a, the n-type impurity concentration is distributed in the depth direction of the semiconductor substrate 12 so as to have a peak value nmax. In other words, the region in which the n-type impurity concentration is normally distributed so as to have the peak value nmax is the current spreading n-layer 40a. In the electric field relaxation n-layer 40b, the n-type impurity concentration is distributed at a substantially constant value that is lower than that in the current spreading n-layer 40a. In the drift layer 40c, the n-type impurity concentration is distributed at a substantially constant value that is lower than that in the electric field relaxation n-layer 40b.

A portion of the current spreading n-layer 40a having the peak value nmax is in contact with the gate insulating film 16 on the side surface 14a of the trench 14 (that is, the surface having a radius of curvature of 0.7 $\mu$m or more). In the first embodiment, the entire current spreading n-layer 40a is in contact with the gate insulating film 16 on the side surface 14a of the trench 14. That is, the current spreading n-layer 40a is not in contact with the gate insulating film 16 at the bottom connection surface 14b of the trench 14. The electric field relaxation n-layer 40b is in contact with the gate insulating film 16 within the range between the current spreading n-layer 40a and the bottom p-layer 36. The electric field relaxation n-layer 40b contacts the gate insulating film 16 at the bottom connection surface 14b.

When the MOSFET 10 is used, a higher potential is applied to the drain electrode 24 as compared to the source electrode 22. The potential of the gate electrode 18 is controlled independently of the potentials of the drain electrode 24 and the source electrode 22. When a potential higher than the gate threshold is applied to the gate electrode 18, a channel is formed in the body layer 34 in a region adjacent to the gate insulating film 16, and the channel connects the source layer 30 and the current spreading n-layer 40a. As a result, electrons flow from the source layer 30 through the channel, the current spreading n-layer 40a, the electric field relaxation n-layer 40b, the drift layer 40c, and the buffer layer 40d to the drain layer 40e. This turns on the MOSFET 10. The current spreading n-layer 40a has a relatively high n-type impurity concentration and therefore has a low resistance. Therefore, electrons that have flowed from the channel into the current spreading n-layer 40a tend to flow in the current spreading n-layer 40a along the x-direction. Therefore, in the drift layer 40c located below the current spreading n-layer 40a, electrons flow toward the drain layer 40e while being dispersed in the x-direction. In this way, electrons flow in a dispersed manner within the drift layer 40c, so that the MOSFET 10 has a low on-resistance.

When the potential of the gate electrode 18 is reduced to a potential below the gate threshold, the channel disappears and the flow of electrons stops. In other words, the MOSFET 10 is turned off. As a result, a depletion layer extends from the body layer 34 into the current spreading n-layer 40a, the electric field relaxation n-layer 40b, and the drift layer 40c. The voltage between the drain electrode 24 and the source electrode 22 is maintained by the depletion layer that spreads in the current spreading n-layer 40a, the electric field relaxation n-layer 40b, and the drift layer 40c. Furthermore, when the MOSFET 10 is turned off, a depletion layer extends from the bottom p-layer 36 into the surrounding electric field relaxation n-layer 40b. The depletion layer extending from the bottom p-layer 36 suppresses electric field concentration near the bottom end of the trench 14.

When the current spreading n-layer 40a and the electric field relaxation n-layer 40b are depleted, an electric field is applied to the gate insulating film 16. The electric field tends to concentrate in the curved portion of the gate insulating film 16. That is, the electric field is more likely to concentrate on the gate insulating film 16 covering the bottom connection surface 14b than on the gate insulating film 16 covering the side surface 14a. On the other hand, if the density of fixed charges present in the depletion layer in contact with the gate insulating film 16 is high, the electric field applied to the gate insulating film 16 becomes strong. That is, the higher the n-type impurity concentration in the n-type layer in contact with the gate insulating film 16, the stronger the electric field applied to the gate insulating film 16. In this embodiment, the electric field relaxation n-layer 40b with a low n-type impurity concentration is in contact with the gate insulating film 16 at the bottom connection surface 14b where electric field concentration is likely to occur. This restricts an excessively high electric field from being applied to the gate insulating film 16 covering the bottom connection surface 14b, and suppresses dielectric breakdown of the gate insulating film 16 in this portion. Further, the current spreading n-layer 40a having a high n-type impurity concentration is connected to the gate insulating film 16 at the side surface 14a where electric field concentration is unlikely to occur. This restricts an excessively high electric field from being applied to the gate insulating film 16 in the area in contact with the current spreading n-layer 40a, and suppresses dielectric breakdown of the gate insulating film 16 in this area.

As described above, according to the MOSFET 10 of this embodiment, the on-resistance of the MOSFET 10 can be reduced by the current spreading n-layer 40a while restricting dielectric breakdown of the gate insulating film 16.

Second Embodiment

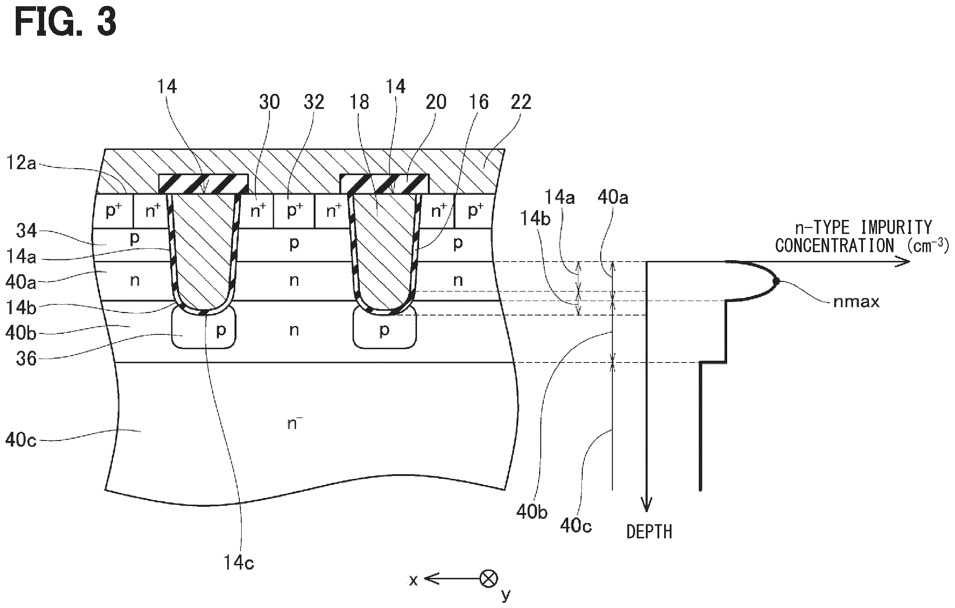

In the MOSFET of the second embodiment shown in FIG. 3, the thickness of the current spreading n-layer 40a is thicker than that of the MOSFET 10 of the first embodiment. Other configurations of the MOSFET of the second embodiment are the same as those of the MOSFET 10 of the first embodiment.

In the second embodiment, the lower end of the current spreading n-layer 40a contacts the gate insulating film 16 at the bottom connection surface 14b. However, a portion of the current spreading n-layer 40a having the peak value nmax is in contact with the gate insulating film 16 at the side surface 14a. That is, the portion having the peak value nmax does not contact the gate insulating film 16 at the bottom connection surface 14b, and a portion of the current spreading n-layer 40a with a low n-type impurity concentration contacts the gate insulating film 16 at the bottom connection surface 14b. Therefore, even in this configuration, the electric field applied to the portion of the gate insulating film 16 covering the bottom connection surface 14b can be suppressed.

Third Embodiment

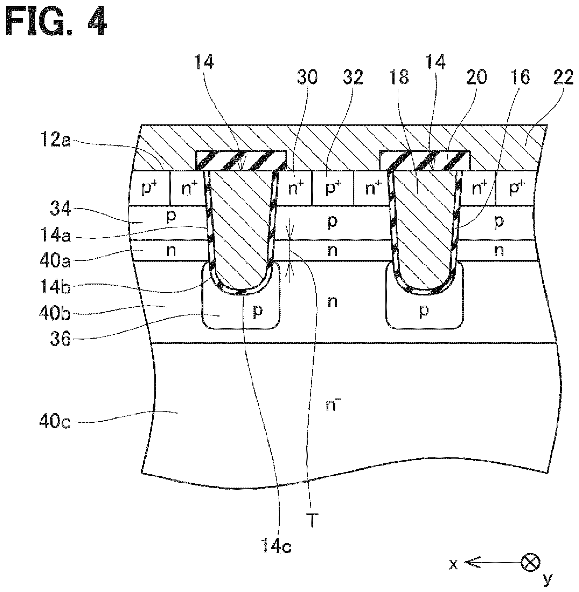

The bottom p-layer 36 may be formed by ion implantation of p-type impurities into the bottom of the trench 14 prior to the formation of the gate electrode 18. In this case, as shown in FIG. 4, the bottom p-layer 36 may be formed so that the bottom p-layer 36 contacts the current spreading n-layer 40a from the lower side in the area in contact with the gate insulating film 16. In this configuration, the bottom p-layer 36 is in contact with the gate insulating film 16 over the entire bottom connection surface 14b. This configuration also makes it possible to reduce the electric field applied to the gate insulating film 16 covering the bottom connection surface 14b.

In FIG. 4, if the thickness T of the current spreading n-layer 40a is too thin, the separation between the body layer 34 and the bottom p-layer 36 becomes insufficient, and the characteristics of the MOSFET deteriorate. In order to reliably separate the body layer 34 and the bottom p-layer 36, the thickness T of the current spreading n-layer 40a between the body layer 34 and the bottom p-layer 36 can be made thicker than the width W of the depletion layer that occurs in the current spreading n-layer 40a when no voltage is applied to the MOSFET. The width W of the depletion layer can be calculated by the following formula.

$$W = (2\varepsilon Vbi/qNd)^{-1/2}$$

In the above formula, $\varepsilon$ is a dielectric constant of the semiconductor substrate 12, Vbi is a built-in potential, q is an elementary charge, and Nd is an n-type impurity concentration of the current spreading n-layer 40a. The built-in potential Vbi can be calculated by the following formula.

$$Vbi = (kT/q) \times \ln(NaNd/ni^2)$$

In the above formula, k is the Boltzmann constant, T is the temperature, Na is the p-type impurity concentration of the body layer 34, and ni is the intrinsic carrier density.

More specifically, when Na=4 x $10^{17}$cm$^{-3}$, Nd=3 x $10^{17}$ cm$^{-3}$, and ni=1 x $10^{-8}$ cm$^{-3}$, the thickness T can be set to 0.1 $\mu$m or more.

Fourth Embodiment

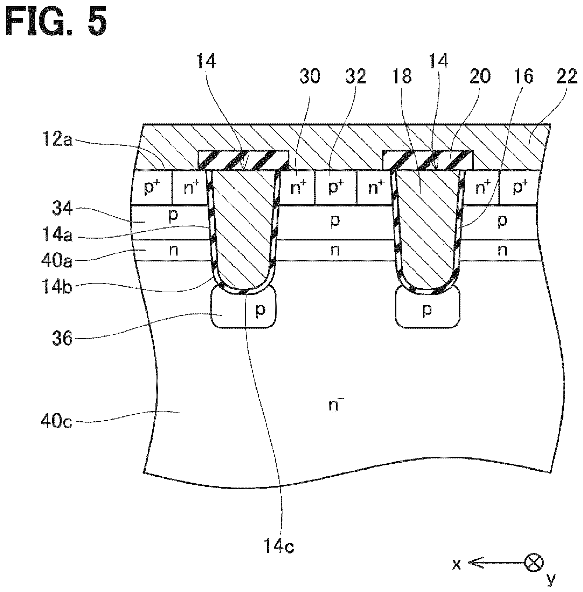

In the MOSFET of the fourth embodiment shown in FIG. 5, the electric field relaxation n-layer 40b does not exist, and the drift layer 40c contacts the current spreading n-layer 40a from the lower side. Other configurations of the MOSFET of the fourth embodiment are the same as those of the MOSFET 10 of the first embodiment. In the fourth embodiment, the drift layer 40c having an even lower n-type impurity concentration than the electric field relaxation n-layer 40b contacts the gate insulating film 16 at the bottom connection surface 14b. Therefore, the electric field applied to the gate insulating film 16 covering the bottom connection surface 14b can be more effectively suppressed.

Fifth Embodiment

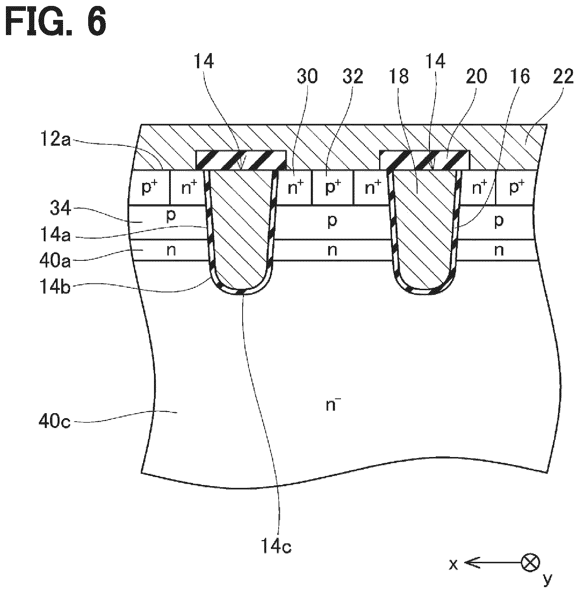

In the MOSFET of the fifth embodiment shown in FIG. 6, the bottom p-layer 36 does not exist. In this case, the connection p-layer 38 does not need to be provided. Other configurations of the MOSFET of the fifth embodiment are the same as those of the MOSFET of the fourth embodiment. This configuration also makes it possible to suppress the electric field applied to the gate insulating film 16 covering the bottom connection surface 14b. In the first and second embodiments, the bottom p-layer 36 may not be provided.

The electric field relaxation n-layer 40b in the first to third embodiments and the drift layer 40c in the fourth and fifth embodiments are examples of a low-concentration n-layer.

Although the embodiments have been described in detail above, these are merely examples and do not limit the scope of claims. The techniques described in claims include various modifications of the specific examples illustrated above. The technical elements described in the present specification or the drawings exhibit technical usefulness alone or in various combinations, and are not limited to the combinations described in the claims at the time of filing. In addition, the techniques illustrated in the present specification or drawings achieve a plurality of objectives at the same time, and achieving one of the objectives itself has technical usefulness.

**Claims**

1. A field effect transistor comprising:

   a semiconductor substrate having a trench on an upper surface;
   a gate insulating film that covers an inner surface of the trench; and
   a gate electrode disposed inside the trench and insulated from the semiconductor substrate by the gate insulating film, wherein
   the semiconductor substrate includes:

   an n-type source layer in contact with the gate insulating film;
   a p-type body layer in contact with the gate insulating film below the source layer; and
   a lower n-layer disposed below the body layer,
   the lower n-layer includes:

   a current spreading n-layer in contact with the body layer from a lower side; and
   a low-concentration n-layer in contact with the current spreading n-layer from a lower side, the low-concentration n-layer having a lower n-type impurity concentration than the current spreading n-layer,
   an n-type impurity concentration distributed in the current spreading n-layer has a peak value in a depth direction of the semiconductor substrate,
   the inner surface of the trench has:

   a side surface having a curvature radius of 0.7 $\mu$m or more; and
   a bottom connection surface to connect the side surface and a lower end of the trench, the bottom connection surface being a concave curved surface having a curvature radius less than 0.7 $\mu$m, and
a portion of the current spreading n-layer having the peak value is in contact with the gate insulating film at the side surface.

2. The field effect transistor according to claim 1, wherein the current spreading n-layer is not in contact with the gate insulating film at the bottom connection surface.

3. The field effect transistor according to claim 1 or 2, further comprising a bottom p-layer in contact with the gate insulating film at the lower end of the trench.

4. The field effect transistor according to claim 3, wherein

   the bottom p-layer is in contact with the current spreading n-layer within a region in contact with the gate insulating film, and
   the current spreading n-layer between the body layer and the bottom p-layer has a thickness of 0.1 $\mu$m or more.

# FIG. 1

# FIG. 2

EP 4 579 759 A1

# FIG. 3

EP 4 579 759 A1

# FIG. 4

# FIG. 5

# FIG. 6

## INTERNATIONAL SEARCH REPORT

| International application No. |
| --- |
| **PCT/JP2023/021200** |

### A. CLASSIFICATION OF SUBJECT MATTER

**H01L 29/78**(2006.01)i
FI:  H01L29/78 652J; H01L29/78 653A; H01L29/78 652K; H01L29/78 652F; H01L29/78 652S

According to International Patent Classification (IPC) or to both national classification and IPC

### B. FIELDS SEARCHED

Minimum documentation searched (classification system followed by classification symbols)

H01L29/78

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| Y | JP 2021-182639 A (MITSUBISHI ELECTRIC CORP) 25 November 2021 (2021-11-25) paragraphs [0025]-[0041], fig. 2-4 | 1-4 |
| Y | JP 2020-031157 A (FUJI ELECTRIC CO LTD) 27 February 2020 (2020-02-27) paragraphs [0039]-[0043], fig. 2, 3 | 1-4 |
| Y | WO 2022/137788 A1 (FUJI ELECTRIC CO LTD) 30 June 2022 (2022-06-30) paragraphs [0014]-[0028], [0041], fig. 1, 7 | 4 |
| A | | 1-3 |
| Y | JP 2022-002345 A (FUJI ELECTRIC CO LTD) 06 January 2022 (2022-01-06) paragraphs [0023]-[0027], fig. 2 | 4 |
| A | | 1-3 |
| Y | JP 2008-016747 A (FUJI ELECTRIC HOLDINGS CO LTD) 24 January 2008 (2008-01-24) paragraph [0018], fig. 1 | 4 |
| A | | 1-3 |

| ✓ | Further documents are listed in the continuation of Box C. | ✓ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **07 August 2023** | **15 August 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT

| International application No. |
|---|
| **PCT/JP2023/021200** |

**C.    DOCUMENTS CONSIDERED TO BE RELEVANT**

| Category* | Citation of document, with indication, where appropriate, of the relevant passages | Relevant to claim No. |
|---|---|---|
| Y | JP 2011-253837 A (DENSO CORP, TOYOTA MOTOR CORP, TOYOTA CENTRAL R&D LABS INC) 15 December 2011 (2011-12-15)<br>      paragraph [0033], fig. 1 | 4 |
| A |  | 1-3 |

Form PCT/ISA/210 (second sheet) (January 2015)

## INTERNATIONAL SEARCH REPORT
### Information on patent family members

International application No.

**PCT/JP2023/021200**

| Patent document cited in search report | | | Publication date (day/month/year) | Patent family member(s) | | | Publication date (day/month/year) |
|---|---|---|---|---|---|---|---|
| JP | 2021-182639 | A | 25 November 2021 | US | 2021/0288156 | A1 | |
| | | | | paragraphs [0062]-[0078], fig. 2-4 | | | |
| | | | | US | 2022/0149167 | A1 | |
| | | | | WO | 2018/225600 | A1 | |
| | | | | DE | 112018002873 | T5 | |
| | | | | CN | 110709997 | A | |
| JP | 2020-031157 | A | 27 February 2020 | (Family: none) | | | |
| WO | 2022/137788 | A1 | 30 June 2022 | US | 2023/0092855 | A1 | |
| | | | | paragraphs [0058]-[0072], [0085], fig. 1, 7 | | | |
| | | | | US | 2023/0092965 | A1 | |
| | | | | EP | 4145533 | A1 | |
| | | | | EP | 4145534 | A1 | |
| | | | | CN | 115699330 | A | |
| | | | | CN | 115917756 | A | |
| JP | 2022-002345 | A | 06 January 2022 | US | 2019/0109228 | A1 | |
| | | | | paragraphs [0037]-[0041], fig. 2 | | | |
| JP | 2008-016747 | A | 24 January 2008 | US | 2008/0012026 | A1 | |
| | | | | paragraph [0041], fig. 1 | | | |
| | | | | US | 2009/0315039 | A1 | |
| | | | | DE | 102007023885 | A1 | |
| JP | 2011-253837 | A | 15 December 2011 | US | 2011/0291110 | A1 | |
| | | | | paragraph [0038], fig. 1 | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022135237 A

- JP 2008235546 A